# EUROPEAN PATENT SPECIFICATION

(11) **EP 1 793 458 B1**
(45) Date of publication and mention of the grant of the patent: **06.08.2008**
(21) Application number: 06023680.9
(22) Date of filing: 14.11.2006
(51) Int. Cl.: H01R 13/73, H05K 5/00

(54) **Connector mounting construction and method**
Verbindermotageanordnung und Verfahren
Dispositif de montage et procédé pour un connecteur

(30) Priority: 30.11.2005 JP 2005346488
(43) Date of publication of application: 06.06.2007
(73) Proprietor: Sumitomo Wiring Systems, Ltd., Yokkaichi-City, Mie, 510-8503 (JP)
(72) Inventor: Maegawa, Akihito, Yokkaichi-city MIE 510-8503 (JP); Nagashima, Shinyu, Yokkaichi-city MIE 510-8503 (JP)
(74) Representative: Müller-Boré & Partner Patentanwälte

(56) References cited:
- DE-A1- 4 101 388
- DE-A1- 19 848 732

## Description

The present invention relates to a construction and a method for mounting a connector in an apparatus or the like.

The following is, for example, known as examples of a construction and a method for mounting an intermediate connector to be installed in an automatic transmission. A connection hole is formed in a lid of a transmission case and a body of a solenoid valve is mounted on the lower surface of the lid. The intermediate connector is used by being vertically mounted, and a fastenable portion to be brought into contact with the bottom surface of the valve body horizontally projects from a bottom end portion of the intermediate connector. An insertion hole for a bolt is formed to vertically penetrate this fastenable portion, and a seal ring is mounted at an upper end of the intermediate connector. After the bolt inserted through the insertion hole from below is screwed into a bolt hole formed in the bottom surface of the valve body to fasten the intermediate connector to the valve body while the fastenable portion of the intermediate connector is placed on the bottom surface of the valve body, the upper end of the intermediate connector is hermetically fitted into the connection hole of the lid. Finally, the valve body is fixed to the lower surface of the lid using another bolt or the like.

A construction for mounting a connector in an apparatus using bolts is disclosed, for example, in Japanese Unexamined Patent Publication No. 2003-31323.

In the case of the above mounting construction, the upper end portion of the intermediate connector cannot be concentrically fitted into the connection hole unless the connection hole of the lid of the transmission case and the bolt hole (insertion hole) of the valve body are spaced apart by a proper specified distance.

If dimensional tolerances in forming the connector, the lid of the transmission case and the valve body, mounting tolerances of the lid and the valve body and other tolerances are added, there is a possibility of a positional displacement between the connecting hole and the bolt hole. Further, the connector is likely to undergo a deformation such as a deflection, for example, if the connector is elongated. Thus, there is also a possibility of a large deviation of the position of the insertion hole from an axis line.

If the connector is mounted as above in this state, the upper end may be fitted into the connection hole while the axis line of the connector is deviated, and stresses may act on the connector or sealing may be impaired to cause leakage.

DE 41 01 388 A1 discloses a method of manufacturing a pre-wired electromechanical device for generating instructions and/or for displaying conditions as well as a corresponding device. Electric modules are mounted on manifolds by means of screws. The channels of the modules for inserting the screws comprise a clearance so as to avoid harmful stress or tension in a printed circuit board.

DE 198 48 732 A1 discloses an electrical connection comprising an angled connector which penetrates a bore in a transmission casing. The connector is fixed in the axial position by means of a holder and fixed in an angular position by means of a rotational lock.

The present invention was developed in view of the above problem, and an object thereof is to provide a mounting construction and a mounting method enabling a connector to be fitted into a mating fitting hole in a natural state.

This object is solved according to the invention by the features of the independent claims. Preferred embodiments of the invention are subject of the dependent claims.

According to the invention, there is provided a connector mounting construction, wherein:
one end of a connector with respect to a direction of an axis line thereof is to be at least partly fitted into a fitting hole formed in a first member,
a fastenable portion projects from or near the other end thereof in a direction intersecting with the axis line and is formed with an insertion hole for a fixing member in a direction substantially parallel to the axis line, and the connector is to be fastened by fixing the fixing member at least partly inserted through the insertion hole into a fixing member hole formed in a second member to be fixed to the first member,
a partial locking mechanism having a clearance for permitting movements of the connector along one or more directions intersecting with the axis line while preventing movements of the connector along the direction of the axis line upon the engagement of a locking portion provided at either one of the second member and the other end of the connector and an engaging portion provided at the other is provided between the second member and the other end of the connector,

wherein the partial locking mechanism includes an engaging groove circumferentially formed on the outer surface of the other end of the connector, and a locking plate projecting from the second member and insertable into the engaging groove-in a direction intersecting with the axis line to be engaged therewith.

Accordingly, the connector can be mounted in the following preferred procedure. The locking portion and the engaging portion provided at the second member and the other end of the connector are engaged to partly lock the connector into the second member while movements of the connector substantially along the direction of the axis line are prevented and those of the connector along directions intersecting with the axis line are permitted. Subsequently, the one end of the connector partly locked into the second member is fitted into the fitting hole of the first member and then the second member is fixed to the first member. Finally, the fixing member is at least partly inserted into the fixing member hole of the second member through the insertion hole of the fastenable portion of the connector, whereby the fastenable portion is fixed to the second member.

Here, if dimensional tolerances in forming the connector, the first member and the second member, mounting tolerances of the first and second members and other tolerances are added, there is a possibility of a deviation of a distance between the fitting hole and the screw hole from a specified one or a large deviation of the position of the insertion hole of the fastenable portion from the axis line due to a deformation.

According to the above, a final operation is to fix or fasten the fastenable portion to the second member with the fixing member. In this case, the insertion hole of the fastenable portion and the fixing member hole of the second member need to be substantially aligned. It is possible to align the insertion hole and the fixing member hole while moving the connector in a direction intersecting with the axis line, utilizing the clearance provided in the partial locking mechanism, and then to fasten the connector with the screw. In other words, the other end of the connector can be fastened to the second member with the fixing member with the one end thereof fitted in the fitting hole of the first member in the vertical posture of the connector where the axis line is not deviated from vertical direction. Thus, the action of a bending stress on the connector can be avoided, and the one end of the connector can be prevented from being forcibly fitted in the fitting hole.

According to a preferred embodiment of the invention, the fixing member comprises a screw and the fixing member hole comprises a screw hole into which the screw can be screwed.

According to a further preferred embodiment of the invention, there is provided a connector mounting construction in which one end of a connector with respect to a direction of an axis line thereof is fitted into a fitting hole formed in a first member, a fastenable portion projects from the other end thereof in a direction intersecting with the axis line and is formed with an insertion hole for a screw in a direction parallel to the axis line, and the connector is fastened by screwing the screw inserted through the insertion hole into a screw hole formed in a second member to be fixed to the first member, characterized in that a partial locking mechanism having a clearance for permitting movements of the connector along directions intersecting with the axis line while preventing movements of the connector along the direction of the axis line upon the engagement of a locking portion provided at either one of the second member and the other end of the connector and an engaging portion provided at the other is provided between the second member and the other end of the connector.

The connector is particularly mounted in the following procedure. The locking portion and the engaging portion provided at the second member and the other end of the connector are engaged to partly lock the connector into the second member while movements of the connector along the direction of the axis line are prevented and those of the connector along directions intersecting with the axis line are permitted. Subsequently, the one end of the connector partly locked into the second member is fitted into the fitting hole of the first member and then the second member is fixed to the first member. Finally, the screw is screwed into the screw hole of the second member through the insertion hole of the fastenable portion of the connector, whereby the fastenable portion is fixed to the second member.

Here, if dimensional tolerances in forming the connector, the first member and the second member, mounting tolerances of the first and second members and other tolerances are added, there is a possibility of a deviation of a distance between the fitting hole and the screw hole from a specified one or a large deviation of the position of the insertion hole of the fastenable portion from the axis line due to a deformation.

According to the above, a final operation is to fasten the fastenable portion to the second member with the screw. In this case, the insertion hole of the fastenable portion and the screw hole of the second member need to be aligned. It is possible to align the insertion hole and the screw hole while moving the connector in a direction intersecting with the axis line, utilizing the clearance provided in the partial locking mechanism, and then to fasten the connector with the screw. In other words, the other end of the connector can be fastened to the second member with the screw with the one end thereof fitted in the fitting hole of the first member in the vertical posture of the connector where the axis line is not deviated from vertical direction. Thus, the action of a bending stress on the connector can be avoided, and the one end of the connector can be prevented from being forcibly fitted in the fitting hole.

Preferably, the fixing member, preferably the screw, is at least partly insertable into the insertion hole of the fastenable portion while defining a clearance thereto.

By utilizing the clearance provided in the insertion hole of the fastenable portion, a positional displacement between the fitting hole and the fixing member hole, preferably the screw hole, and a deviation of the position of the insertion hole can be taken up in a wider range.

Further preferably, the locking plate and the engaging groove are or are so to be arranged as to define the clearance therebetween for permitting movements of the connector along directions intersecting with the axis line.

In a part constructing the partial locking mechanism, the locking plate projecting from the second member is inserted into the engaging groove circumferentially formed on the outer surface of the other end of the connector along the direction intersecting with the axis line of the connector to define the clearance between the locking plate and the bottom of the engaging groove. Thus, the connector can be partly locked while movements thereof along the direction of the axis line are prevented, but those thereof along the directions intersecting with the axis line are permitted.

According to the invention, there is further provided a connector mounting method, in particular using a connector mounting construction according to the invention or a preferred embodiment thereof, for fitting one end of a connector with respect to a direction of an axis line thereof into a fitting hole formed in a first member, and fastening the connector by a fixing member at least partly inserted through an insertion hole formed in a fastenable portion projecting at or near the other end of the connector in a direction intersecting with the axis line into a fixing member hole formed in a second member to be fixed to the first member, wherein movements of the connector along one or more directions intersecting with the axis line are permitted by means a partial locking mechanism having a clearance while preventing movements of the connector along the direction of the axis line upon the engagement of a locking portion provided at either one of the second member and the other end of the connector and an engaging portion provided at the other is provided between the second member and the other end of the connector, comprising the steps of:
engaging the locking portion and the engaging portion of the partial locking mechanism with each other,
at least partly fitting the one end of the connector into the fitting hole of the first member,
fixing the second member to the first member, and
at least partly inserting the fixing member into the fixing member hole of the second member through the insertion hole of the fastenable portion.

According to a preferred embodiment of the invention, the step of at least partly inserting the fixing member comprises screwing a screw into a screw hole of the second member through the insertion hole of the fastenable portion.

According to a further preferred embodiment of the invention, there is provided a connector mounting method for fitting one end of a connector with respect to a direction of an axis line thereof into a fitting hole formed in a first member, and fastening the connector by screwing a screw inserted through an insertion hole formed in a fastenable portion projecting at the other end of the connector in a direction intersecting with the axis line into a screw hole formed in a second member to be fixed to the first member, wherein a partial locking mechanism having a clearance for permitting movements of the connector along directions intersecting with the axis line while preventing movements of the connector along the direction of the axis line upon the engagement of a locking portion provided at either one of the second member and the other end of the connector and an engaging portion provided at the other is provided between the second member and the other end of the connector, comprising the steps of:
engaging the locking portion and the engaging portion of the partial locking mechanism with each other,
fitting the one end of the connector into the fitting hole of the first member,
fixing the second member to the first member, and
screwing the screw into the screw hole of the second member through the insertion hole of the fastenable portion.

Preferably, in the step of at least partly inserting the fixing member the fixing member, preferably the screw, is at least partly inserted into the insertion hole of the fastenable portion while defining a clearance thereto.

Further preferably, the partial locking mechanism includes an engaging groove circumferentially formed on the outer surface of the other end of the connector, and a locking plate projecting from the second member and insertable into the engaging groove in a direction intersecting with the axis line to be engaged therewith.

Most preferably, the locking plate and the engaging groove are so arranged as to define the clearance therebetween for permitting movements of the connector along directions intersecting with the axis line.

These and other objects, features and advantages of the present invention will become more apparent upon reading of the following detailed description of preferred embodiments and accompanying drawings. It should be understood that even though embodiments are separately described, single features thereof may be combined to additional embodiments.
FIG. 1 is a front view showing an operation of partly locking a housing according to one embodiment of the present invention,
FIG. 2 is a front view showing a state where the housing is partly locked,
FIG. 3 is a front view partly in section showing an operation of fitting an upper end portion of the housing into a fitting hole of a lid,
FIG. 4 is a front view partly in section showing an operation of fixing a valve body to the lid,
FIG. 5 is a front view partly in section showing an operation of fastening a fastenable portion of the housing to the valve body,
FIG. 6 is a front view partly in section when the assembling of the transmission is completed,
FIG. 7 is a section showing a construction for fastening the fastenable portion,
FIG. 8 is a plan view in section showing a partly locking operation, and
FIG. 9 is a plan view in section showing a partly locked state.

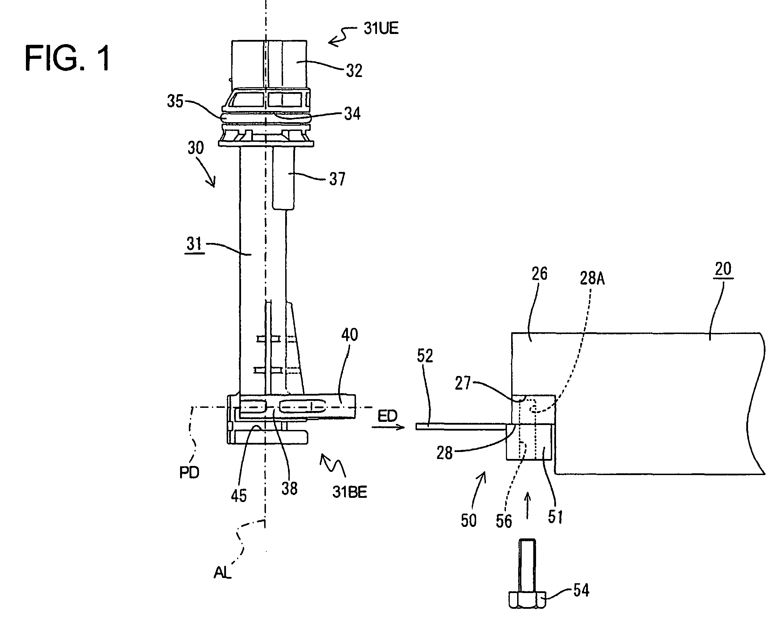

Hereinafter, one preferred embodiment of the present invention is described with reference to FIGS. 1 to 9. In this embodiment is shown an example in which an intermediate connector 30 is mounted in or to an automatic transmission.

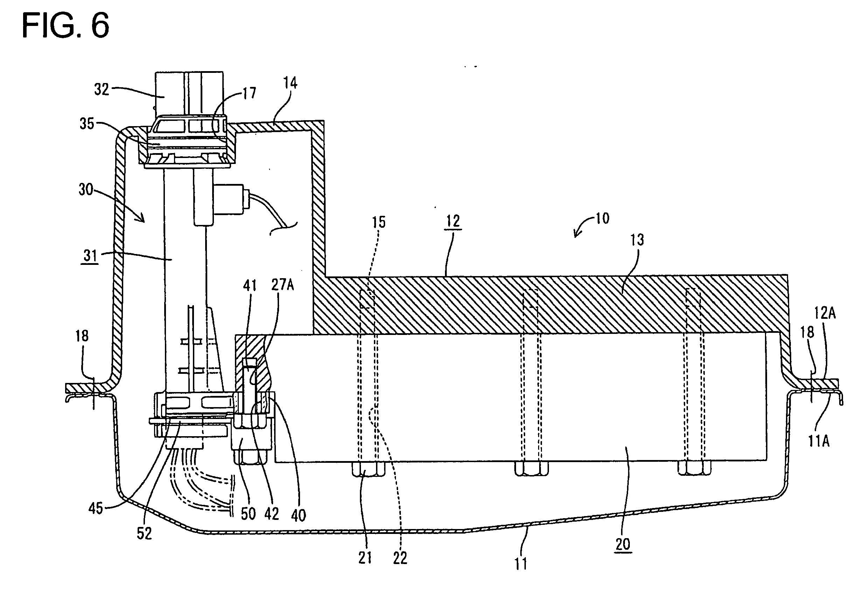

As shown in FIG. 6, a transmission case 10 is constructed such that a lid 12 e.g. of synthetic resin is mounted on a lateral (upper) opening of a substantially pan-shaped case main body 11 made e.g. of a different material than the lid such as metal or alloy. one part (preferably more than about half area, more preferably a substantially two-thirds area) of the lid 12 at one side is a lowered portion 13 and the remaining area is an elevated portion 14. The lowered portion 13 preferably is formed to be thick and a valve body 20 is to be mounted on the inner (lower) surface of the lowered portion 13.

The valve body 20 preferably substantially is in the form of a block made e.g. of synthetic resin and is so dimensioned as to extend from the substantially entire area of the lowered portion 13 slightly into the formed area of the elevated portion 14. After the valve body 20 is at least partly brought into contact with the inner (lower) surface of the lowered portion 13, one or more, preferably a plurality of through bolts 21 are inserted through insertion holes 22 (preferably from inside or below) and screwed into bolt holes 51 formed in the respective (lower) surface of the lowered portion 13 to fix the valve body 20.

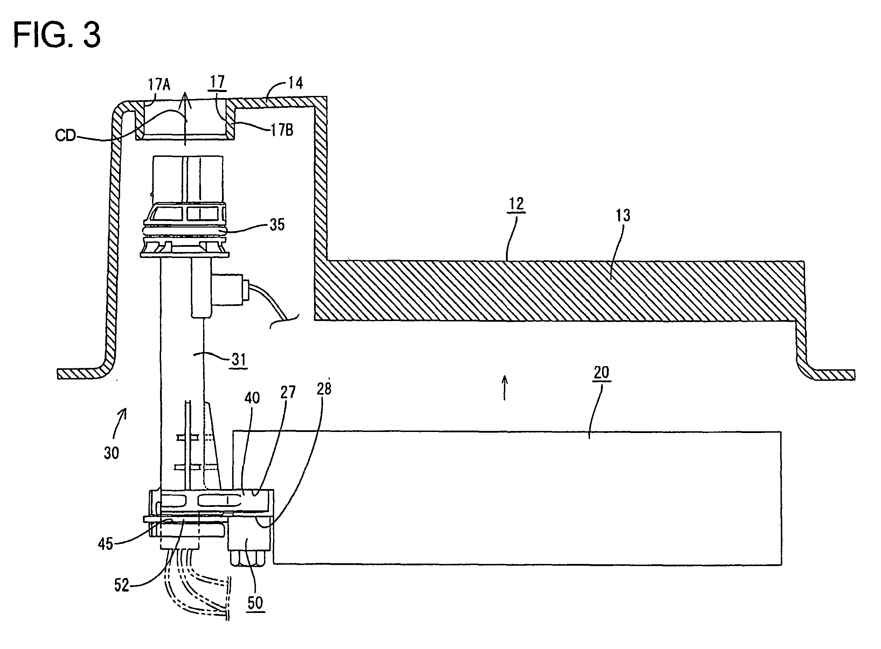

On the other hand, the elevated portion 14 is formed with a fitting hole 17 into which an upper or distal end portion 31 UE of the intermediate connector 30 to be described later is or can be at least partly fitted. Specifically, this fitting hole 17 is, as shown in FIG. 3, formed such that a (preferably substantially cylindrical) portion 17B of a specified (predetermined or predeterminable) height is substantially continuous with the opening edge at the underside of a mating (preferably substantially round) hole 17A formed in the elevated portion 14.

An outward projecting flange 12A is formed over at least part, preferably over substantially the entire circumference at a lateral (lower) opening of the lid 12, and a flange 11 A preferably having substantially the same width is formed over at least part, preferably over substantially the entire circumference at a lateral (upper) opening of the case main body 11. The flange 12A of the lid 12 is placed on the flange 11A of the case main body 11 and coupled thereto at a plurality of positions circumferential spaced apart at specified (predetermined or predeterminable) intervals using screws 18 or the like. Thus, the lid 12 is mounted on the lateral (upper) surface of the case main body 11 as described above.

As shown in FIG. 1, the intermediate connector 30 has a vertically long connector housing 31 (hereinafter, merely "housing 31 ") made e.g. of synthetic resin. An upper or distal end portion 31 UE of this housing 31 is at least partly fittable or insertable into the fitting hole 17 of the lid 12 of the above transmission case 10. An external connector portion 32 to be connected with a connector (not shown) arranged outside is formed to substantially face outward or upward at the distal or upper end surface 31 UE of the housing 31. A seal-ring mounting groove 34 preferably is formed over the entire circumference of the outer circumferential surface at the bottom (or behind as seen in a connecting direction CD) of the external connector portion 32, and a seal ring 35 is mounted therein or thereon. Sealing is given by fitting the external connector portion 32 into the fitting hole 17 while resiliently compressing this seal ring 35.

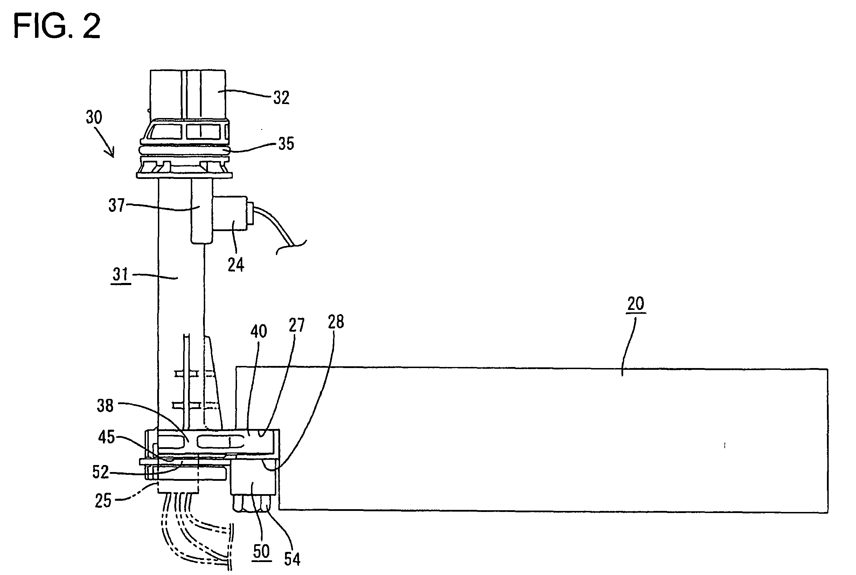

A first internal connector portion 37 projects forward from the plane of FIG. 1 at a position of the housing 31 near the distal or upper end portion 31 UE, and a mating connector 24 (see FIG. 2) drawn out from the valve body 20 is connected or connectable therewith laterally (from the right side of FIG. 1). Further, a second internal connector portion 38 projects forward from the plane of FIG. 1, and another connector 25 (see FIG. 2) drawn out from the valve body 20 is connected or connectable therewith from another direction (e.g. from below).

The other distal (bottom) end side 31 BE of the housing 31 is or can be fixed to the valve body 20. To this end, a fastenable portion 40 laterally or horizontally projects (integrally or unitarily) from the housing 31 (or projects therefrom in a projecting direction PD intersecting the longitudinal direction or axis line AL of the housing 31), preferably from another end 31 BE of the housing 31, preferably from the second internal connector portion 38 provided in or on the housing 31. This fastenable portion 40 preferably is in the form of a thick plate projecting laterally (toward the right side of FIG. 1).

On the other hand, a mounting portion 26 projects from a lateral (upper) part of the distal (left) end surface of the valve body 20 in FIG. 1. The lateral (lower) surface of this mounting portion 26 is stepped such that the front side thereof is higher and the back side thereof is lower, and the fastenable portion 40 of the housing 31 is brought or bringable into contact with a mounting surface 27 at the front and higher side (hereinafter, "higher mounting surface 27"). It should be noted that a bracket 50 to be described later is or can be mounted on a mounting surface 28 at the back and lower side (hereinafter, "lower mounting surface 28").

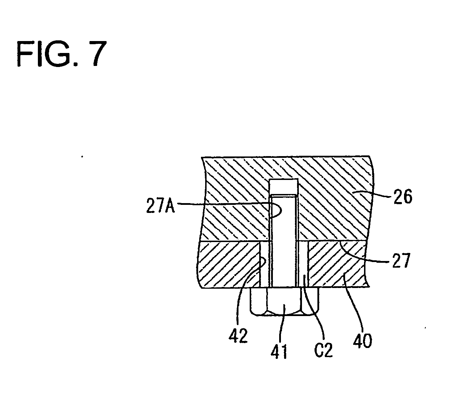

As shown in FIGS. 6 and 7, at least one insertion hole 42 through which at least one bolt 41 is at least partly inserted is formed to (preferably substantially vertically) penetrate the fastenable portion 40 of the housing 31, whereas a bolt hole 27A into which the bolt 41 is screwed is formed in the higher mounting surface 27 of the valve body 20. When the housing 31 in a straight posture where the axis line AL thereof preferably extends substantially in vertical direction and the upper end portion 31 UE thereof is at least partly fitted into the fitting hole 17 of the lid 12, the fastenable portion 40 is brought substantially into close contact with the higher mounting surface 27 of the valve body 20 and the insertion hole 42 for the bolt 41 and the bolt hole 27A preferably are substantially concentrically aligned.

Further, as shown in detail in FIG. 7, the insertion hole 42 for the bolt 41 has a diameter larger than that of a shaft portion of the bolt 41 by a specified (predetermined or predeterminable) dimension. In other words, the bolt 41 is at least partly insertable into the insertion hole 42 while defining a specified (predetermined or predeterminable) clearance C2 thereto.

As described above, the bottom end side 31 BE of the housing 31 is partly coupled to the valve body 20 before the fastenable portion 40 of the housing 31 is fixed to the valve body 20.

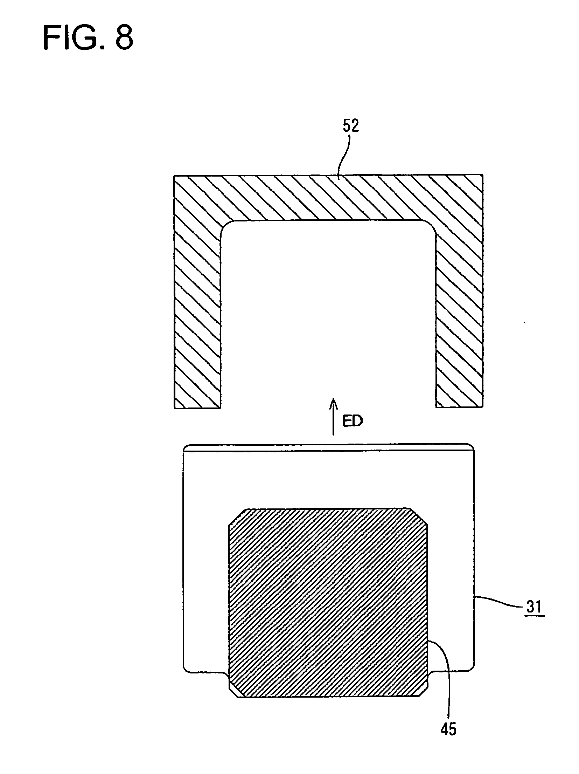

To this end, a distal (bottom) end portion 31 BE of the housing 31 preferably is formed to have a substantially rectangular shape and an engaging groove 45 having a specified (predetermined or predeterminable) depth and/or a specified (predetermined or predeterminable) width is formed in three side surfaces at a position adjacent (preferably substantially right below or neighboring) the aforementioned fastenable portion 40 as shown in FIG. 8. The three side surfaces where the engaging groove 45 is formed are the right, front and back surfaces of FIG. 1, so that the side surface where the engaging groove 45 is not formed is located at a side substantially opposite to the valve body 20 when the fastenable portion 40 is placed on the higher mounting surface 27.

On the other hand, the bracket 50 is to be mounted on the valve body 20. This bracket 50 is constructed such that a locking plate 52 preferably made of metal is formed to project from a lateral (upper) end of one surface of a base body 51 made e.g. of synthetic resin by insert molding or the like. As shown in FIG. 8, the locking plate 52 is substantially bridge- or gate-shaped e.g. as if obtained by omitting one side of a substantially rectangular frame, and is at least partly insertable into the engaging groove 45 of the housing 31.

The bracket 50 is to be fixed by a bolt 54 with the base body 51 held substantially in contact with the lower mounting surface 28 of the valve body 20. To this end, an insertion hole 56 for the bolt 54 is formed in the base body 51, and a bolt hole 28A is formed in the lower mounting surface 28. The bracket 50 is to be fixed such that an opening of the locking plate 52 faces laterally (to the left of FIG. 1). With the housing 31 substantially in the vertical posture at least partly fitted in the fitting hole 17, the locking plate 52 of the bracket 50 is at least partly inserted into the engaging groove 45 of the housing 31 in a direction at an angle different from 0° or 180°, preferably substantially normal to the axis line (e.g. from the right side of FIG. 1).

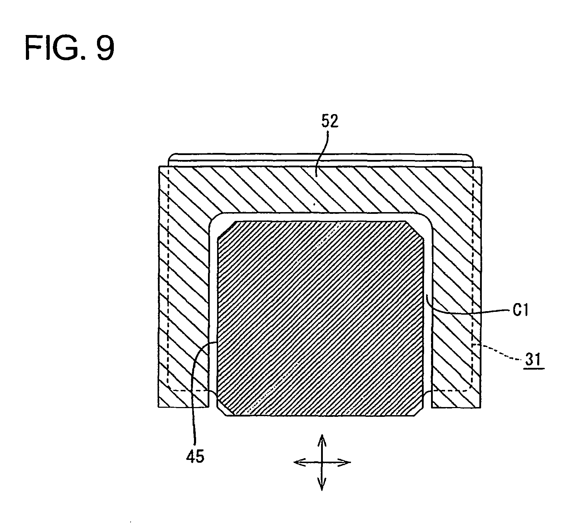

The thickness of the locking plate 52 preferably is formed to be slightly smaller than the width of the engaging groove 45, wherefore the locking plate 52 is substantially closely inserted into the engaging groove 45 with respect to a direction of the axis line AL of the housing 31 (vertical direction) to substantially restrict movements of the housing 31 along this direction. On the other hand, with respect to directions at an angle different from 0° or 180°, preferably substantially normal to axis line AL of the housing 31, the specified (predetermined or predeterminable) clearance C1 is set between the three inner edges of the locking plate 52 and the three sides of the engaging groove 45 facing these inner edges as shown in FIG. 9, wherefore the housing 31 is permit to move substantially along the directions at an angle different from 0° or 180°, preferably substantially normal to the axis line AL of the housing 31 with the locking plate 52 at least partly inserted in the engaging groove 45.

A preferred partial locking mechanism (or movement allowing construction for allowing a movement of the housing 31 in specified (predetermined or predeterminable) directions) comprises the locking plate 52 of the bracket 50 and the engaging groove 45 formed in the housing 31.

Next, a mounting procedure of the intermediate connector 30 is described.

First, as shown in FIG. 1, the base body 51 of the bracket 50 is brought substantially into contact with the lower mounting surface 28 of the valve body 20 and the bolt 54 is screwed into the bolt hole 28A from the lower surface of the base body 51, whereby the locking plate 52 is so fixed as to face in a direction at an angle different from 0° or 180°, preferably substantially normal to the axis line or laterally (to the left of FIG. 1). Subsequently, the engaging groove 45 at the bottom end 31 BE of the housing 31 is engaged with the inner side of the locking plate 52 in an engagement direction ED (being arranged at an angle different from 0° or 180°, preferably substantially normal to the axis line AL) as shown by arrows of FIGS. 1 and 8, and the fastenable portion 40 is placed substantially along the higher mounting surface 27 of the valve body 20 as shown in FIG. 2.

In this way, the housing 31 is partly locked into the bracket 50, i.e. the valve body 20, while movements thereof along the direction of the axis line AL thereof substantially are restricted. At this time, movements of the housing 31 along the directions at an angle different from 0° or 180°, preferably substantially normal to the axis line AL of the housing 31 are permitted. In this partly locked state, the mating connectors 24, 25 drawn out from the valve body 20 are or can be connected with the internal connector portions 37, 38.

Subsequently, as shown in FIG. 3, the distal (upper) end portion 31 UE of the housing 31 is at least partly fitted into the fitting hole 17 of the lid 12 in the connecting direction CD (being preferably substantially along the axis line AL) preferably while resiliently compressing the seal ring 35, and the valve body 20 is brought substantially into contact with the inner or lower surface of the lowered portion 13 of the lid 12.

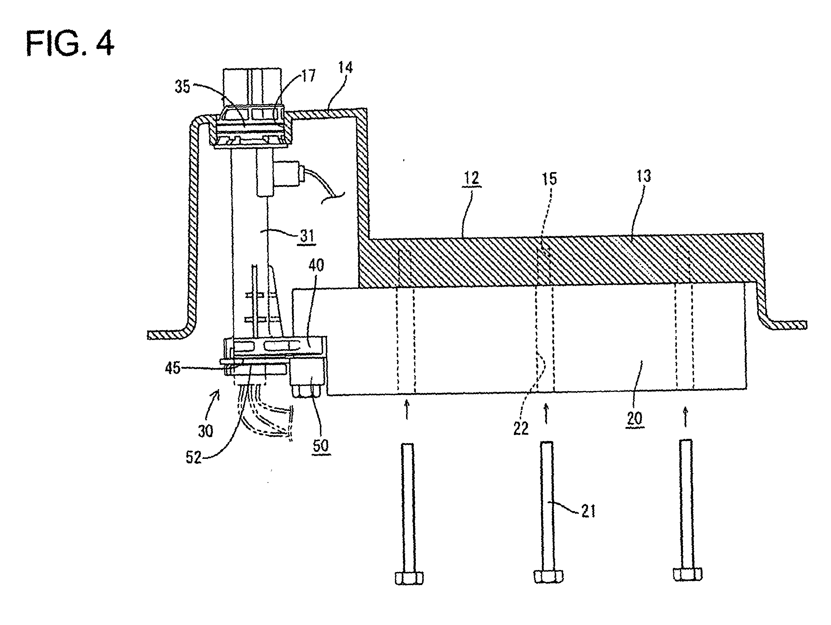

Thereafter, as shown in FIG. 4, the bolts 21 are at least partly inserted into the insertion holes 22 of the valve body 20 from below and screwed into the bolt holes 15 formed in the lower surface of the lowered portion 13, whereby the valve body 20 is fixed to the lower surface of the lowered portion 13.

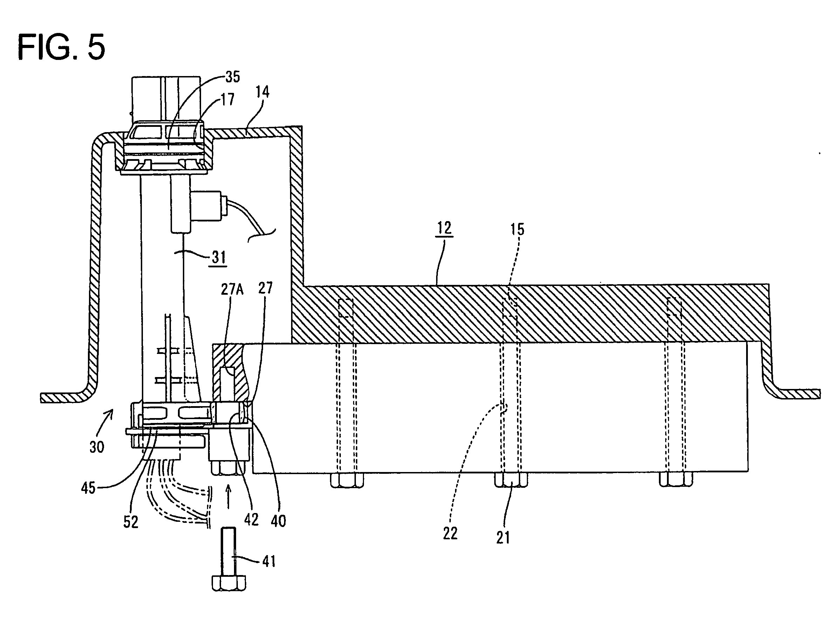

Finally, as shown in FIG. 5, the bolt 41 is at least partly inserted through the insertion hole 42 laterally (from below or preferably substantially along the axis line AL) and screwed into the bolt hole 27A to fix the housing 31 after the insertion hole 42 of the fastenable portion 40 of the housing 31 is substantially aligned with the bolt hole 27A formed in the higher mounting surface 27.

Thereafter, as shown in FIG. 6, the flange 12A of the lid 12 having the valve body 20 and the housing 31 mounted thereon is placed on the flange 11A of the case main body 11, and the lid 12 is fastened preferably at a plurality of positions using the screws 18 to be fixedly mounted on the upper surface of the case main body 11, thereby completing the assembling of the transmission case 10.

Here, at positions where the distal (upper) end portion 31 UE of the housing 31 is at least partly fitted into the fitting hole 17 of the lid 12 and the bottom end portion 31 BE of the housing 31 is fixed to the valve body 20 fixed to the lid 12 using the bolt 41, if dimensional tolerances in forming the housing 31, the lid 12 and the valve body 20 made of synthetic resin, mounting tolerances of the lid 12 and the valve body 20 and other tolerances are added, there is a possibility of a positional displacement between the fitting hole 17 of the lid 12 and the bolt hole 27A formed in the higher mounting surface 27 of the valve body 20 or a large deviation of the position of the insertion hole 42 of the fastenable portion 40 from the axis line AL of the housing 31 due to a deformation such as a deflection resulting from the elongated shape of the housing 31.

In this embodiment, a final operation is to fasten the fastenable portion 40 to the valve body 20 with the bolt 41. In this case, the insertion hole 42 of the fastenable portion 40 and the bolt hole 27A formed in the higher mounting surface 27 of the valve body 20 need to be substantially concentrically aligned. It is possible to substantially align the insertion hole 42 and the bolt hole 27A while moving the housing 31 along a direction intersecting with the axis line AL of the housing 31 as shown by arrows of FIG. 9, utilizing the clearance C1 defined in the partial locking mechanism, i.e. between the locking plate 52 and the engaging groove 45 and then to tighten the bolt 41. In other words, the other distal (bottom) end portion 31 BE of the housing 31 can be fastened and fixed to the valve body 20 with the distal (upper) end portion 31 UE thereof at least partly fitted in the fitting hole 17 of the lid 12 (preferably substantially in the vertical posture of the housing 31 where the axis line AL of the housing 31 is not deviated from vertical direction). Thus, the action of a bending stress on the housing 31 can be avoided to improve durability and the like. Further, the distal (upper) end portion 31 UE of the housing 31 having the seal ring 35 mounted thereon can be prevented from being forcibly fitted in the fitting hole 17. In other words, the seal ring 35 is substantially evenly resiliently compressed over the entire inner circumferential surface of the fitting hole 17, thereby ensuring sealability.

Further, since the bolt 41 is at least partly insertable into the insertion hole 42 of the fastenable portion 40 while defining a clearance C2 thereto as shown in FIG. 7, a positional displacement between the fitting hole 17 and the bolt hole 27A and/or a deviation of the position of the insertion hole 42 with respect to the bolt hole 27A can be taken up in a wider range, utilizing the clearance C2.

Further, a case where the axis line of the insertion hole 42 and that of the bolt hole 27A are inclined with respect to each other can also be dealt with.

Accordingly, to enable a connector to be fitted into a mating fitting hole in a natural state, a distal (upper) end portion 31 UE of a housing 31 is at least partly fitted into a fitting hole 17 formed in a lid 12, and a fastenable portion 40 laterally or horizontally projects from a bottom end portion 31 BE of the housing 31 (or projects in a direction at an angle different from 0° or 180°, preferably substantially normal to an axis line AL of the housing 31), wherein an insertion hole 42 is vertically formed (or formed substantially along the axis line AL) and a bolt 41 is screwed into a bolt hole 27A of a valve body 20 fixed to the lid 12 through the insertion hole 42 to fix the housing 31. An engaging groove 45 is circumferentially formed at the bottom end portion 31 BE of the housing 31, whereas a gate-shaped locking plate 52 projects from the valve body 20 and is at least partly inserted into the engaging groove 45 while defining a clearance thereto, thereby forming a partial locking mechanism for permitting movements of the housing 31 along directions intersecting with an axis line AL of the housing 31 while preventing movements of the housing substantially along a direction of the axis line AL thereof. The bolt 41 is at least partly insertable into the insertion hole 42 of the fastening portion 40 while defining a clearance thereto.

### <Other Embodiments>

The present invention is not limited to the above described and illustrated embodiment. For example, the following embodiment is also embraced by the technical scope of the present invention as defined by the claims.
(1) It is not necessary to provide the clearance extra in the insertion hole of the fastenable portion if the positional displacement between the fitting hole of the lid and the bolt hole of the valve body and the deviation of the insertion hole of the fastenable portion from the bolt hole 27A can be taken up only by the clearance provided in the partial locking mechanism. Such an embodiment is also embraced by the technical scope of the present invention.
(2) The partial locking mechanism is not limited to the construction shown in the foregoing embodiment to insert the locking plate into the engaging groove. Another construction may be employed provided that a clearance is provided to permit movements of the housing along directions intersecting with the axis line of the housing while movements of the housing along the direction of the axis line thereof are prevented upon the engagement of the locking portion provided at either one of the valve body and the bottom end portion of the housing with the engaging portion provided at the other.
(3) The present invention is not limited to application to the intermediate connector to be mounted in the automatic transmission as described and shown in the foregoing embodiment, and is also applicable to intermediate connectors to be mounted in other devices and connectors used for other purposes, such as junction boxes, instrument panels or any other electric or electronic device or appliance. In short, the present invention is widely applicable to mounting constructions in general in which one end of a connector is at least partly fitted into a fitting hole of a first member and a fastenable portion projecting at or near the other end of the connector is fixed to a second member to be fixed to the first member by screwing a bolt in a direction substantially parallel to the direction of the axis line of the connector.

### LIST OF REFERENCE NUMERALS

- 12: lid (first member)
- 17: fitting hole
- 20: valve body (second member)
- 27: higher mounting surface
- 27A: bolt hole (screw hole)
- 30: intermediate connector (connector)
- 31: connector housing
- 31UE: distal (upper) end portion (one end)
- 31BE: other distal (bottom) end portion (other end)
- 35: seal ring
- 40: fastenable portion
- 41: bolt (screw, fixing member)
- 42: insertion hole
- 45: engaging groove (engaging portion: partial locking mechanism)
- 50: bracket
- 52: locking plate (locking portion: partial locking mechanism)
- C1: clearance (in the partial locking mechanism)
- C2: clearance (in the insertion hole 42)

## Claims

1. A connector mounting construction, wherein:
one end (31 UE) of a connector (30) with respect to a direction of an axis line (AL) thereof is to be at least partly fitted into a fitting hole (17) formed in a first member (12),
a fastenable portion (40) projects from or near the other end thereof in a direction (PD) intersecting with the axis line (AL) and is formed with an insertion hole (42) for a fixing member (41) in a direction substantially parallel to the axis line (AL), and the connector is to be fastened by fixing the fixing member (41) at least partly inserted through the insertion hole (42) into a fixing member hole (27A) formed in a second member (20) to be fixed to the first member (12),
a partial locking mechanism (45; 52) having a clearance (C1) for permitting movements of the connector (30) along one or more directions intersecting with the axis line (AL) while preventing movements of the connector (30) along the direction of the axis line (AL) upon the engagement of a locking portion (52) provided at either one of the second member (20) and the other end (31 BE) of the connector (30) and an engaging portion (45) provided at the other is provided between the second member (20) and the other end (31 BE) of the connector (30),
**characterized in that**
the partial locking mechanism (45; 52) includes an engaging groove (45) circumferentially formed on the outer surface of the other end (31 BE) of the connector (30), and a locking plate (52) projecting from the second member (20) and insertable into the engaging groove (45) in a direction intersecting with the axis line (AL) to be engaged therewith.

2. A connector mounting construction according to claim 1, wherein the fixing member (41) comprises a screw (41) and the fixing member hole (27A) comprises a screw hole (27A) into which the screw (41) can be screwed.

3. A connector mounting construction according to one or more of the preceding claims, wherein the fixing member (41), preferably the screw (41), is at least partly insertable into the insertion hole (42) of the fastenable portion (40) while defining a clearance (C2) thereto.

4. A connector mounting construction according to one or more of the preceding claims, wherein the locking plate (52) and the engaging groove (45) are so to be arranged as to define the clearance (C1) therebetween for permitting movements of the connector (30) along directions intersecting with the axis line (AL).

5. A connector mounting method for a connector mounting construction according to one of the preceding claims, wherein movements of the connector (30) along one or more directions intersecting with the axis line (AL) are permitted by means a partial locking mechanism (45; 52) having a clearance (C1) while preventing movements of the connector (30) along the direction of the axis line (AL) upon the engagement of a locking portion (52) provided at either one of the second member (20) and the other end (31 BE) of the connector (30) and an engaging portion (45) provided at the other is provided between the second member (20) and the other end (31 BE) of the connector (30), the method comprising the steps of:
engaging the locking portion (52) and the engaging portion (45) of the partial locking mechanism with each other,
at least partly fitting the one end (31 UE) of the connector (30) into the fitting hole (17) of the first member (12),
fixing the second member (20) to the first member (12), and
at least partly inserting the fixing member (41) into the fixing member hole (27A) of the second member (20) through the insertion hole (42) of the fastenable portion (40).

6. A connector mounting method according to claim 5, wherein the step of at least partly inserting the fixing member (41) comprises screwing a screw (41) into a screw hole (27A) of the second member (20) through the insertion hole (42) of the fastenable portion (40).

7. A connector mounting method according to claim 5 or 6, wherein in the step of at least partly inserting the fixing member (41) the fixing member (41), preferably the screw (41), is at least partly inserted into the insertion hole (42) of the fastenable portion (40) while defining a clearance (C2) thereto.

8. A connector mounting method according to one or more of the preceding claims 5 to 7, wherein the partial locking mechanism (45; 52) includes an engaging groove (45) circumferentially formed on the outer surface of the other end (31 BE) of the connector (30), and a locking plate (52) projecting from the second member (20) and insertable into the engaging groove (45) in a direction intersecting with the axis line (AL) to be engaged therewith.

9. A connector mounting method according to claim 8, wherein the locking plate (52) and the engaging groove (45) are so arranged as to define the clearance (C1) therebetween for permitting movements of the connector (30) along directions intersecting with the axis line (AL).

## Patentansprüche

1. Verbindermontageanordnung bzw. -konstruktion, wobei:
ein Ende (31UE) eines Verbinders (30) in bezug auf eine Richtung einer Achsenlinie (AL) davon wenigstens teilweise in ein einpassendes bzw. Einpaßloch (17) einzupassen ist, welches in einem ersten Glied (12) ausgebildet ist,
ein festlegbarer Abschnitt (40) von oder nahe dem anderen Ende davon in einer Richtung (PD) vorragt, welche die Achsenlinie (AL) schneidet bzw. kreuzt, und mit einem Einsetzloch (42) für ein festlegendes bzw. Festlegungsglied (41) in einer Richtung im wesentlichen parallel zu der Achsenlinie (AL) ausgebildet ist, und der Verbinder durch ein Festlegen bzw. Fixieren des festlegenden Glieds (41), welches wenigstens teilweise durch das Einsetzloch (42) eingesetzt ist, in ein Festlegungsgliedloch (27A) festzulegen ist, welches in einem zweiten Glied (20) ausgebildet ist, um an dem ersten Glied (12) fixiert bzw. festgelegt zu sein bzw. zu werden,
ein teilweiser verriegelnder bzw. Verriegelungsmechanismus (45; 52), welcher einen Abstand bzw. Freiraum (C1) aufweist, um Bewegungen des Verbinders (30) entlang einer oder mehrerer Richtung(en) zu erlauben, welche die Achsenlinie (AL) schneidet (schneiden), während Bewegungen des Verbinders (30) entlang der Richtung der Achsenlinie (AL) bei dem Eingriff eines verriegelnden bzw. Verriegelungsabschnitts (52), welcher an irgendeinem des zweiten Glieds (20) und
des anderen Endes (31BE) des Verbinders (30) zur Verfügung gestellt ist, und eines eingreifenden bzw. Eingriffsabschnitts (45) verhindert sind bzw. werden, welcher an dem anderen vorgesehen bzw. zur Verfügung gestellt ist, zwischen dem zweiten Glied (20) und dem anderen Ende (31BE) des Verbinders (30) vorgesehen bzw. zur Verfügung gestellt ist,
**dadurch gekennzeichnet, daß**
der teilweise Verriegelungsmechanismus (45; 52) eine eingreifende bzw. Eingriffsrille (45), welche in Umfangsrichtung an der äußeren Oberfläche des anderen Endes (31BE) des Verbinders (30) ausgebildet ist, und eine verriegelnde bzw. Verriegelungsplatte (52) beinhaltet, welche von dem zweiten Glied (20) vorragt und in die eingreifende Rille bzw. Nut (45) in einer Richtung einsetzbar ist, welche die Achsenlinie (AL) schneidet bzw. kreuzt, um damit in Eingriff zu gelangen bzw. gebracht zu werden.

2. Verbindermontageanordnung nach Anspruch 1, wobei das festlegende Glied (41) eine Schraube (41) umfaßt und das Festlegungsgliedloch (27A) ein Schraubenloch (27A) umfaßt, in welches die Schraube (41) verschraubt werden kann.

3. Verbindermontageanordnung nach einem oder mehreren der vorangehenden Ansprüche, wobei das festlegende Glied (41), vorzugsweise die Schraube (41) wenigstens teilweise in das Einsetzloch (42) des festlegbaren Abschnitts (40) einsetzbar ist, während ein Freiraum bzw. Abstand (C2) dazu definiert ist bzw. wird.

4. Verbindermontageanordnung nach einem oder mehreren der vorangehenden Ansprüche, wobei die verriegelnde Platte (52) und die eingreifende Rille (45) anzuordnen sind, um den Freiraum (C1) dazwischen zu definieren, um Bewegungen des Verbinders (30) entlang von Richtungen zu erlauben, welche die Achsenlinie (AL) schneiden bzw. kreuzen.

5. Verbindermontageverfahren für eine Verbindermontageanordnung nach einem der vorangehenden Ansprüche, wobei Bewegungen des Verbinders (30) entlang einer oder mehrerer Richtung(en), welche die Achsenlinie (AL) schneidet (schneiden), mittels eines teilweisen verriegelnden bzw. Verriegelungsmechanismus (45; 52) erlaubt werden, welcher einen Freiraum (C1) aufweist, während Bewegungen des Verbinders (30) entlang der Richtung der Achsenlinie (AL) bei dem Eingriff eines verriegelnden Abschnitts (52) verhindert werden, welcher an einem des zweiten Glieds (20) und des anderen Endes (31BE) des Verbinders (30) vorgesehen wird, und ein eingreifender Abschnitt (45), welcher an dem anderen vorgesehen wird, zwischen dem zweiten Glied (20) und dem anderen Ende (31BE) des Verbinders (30) vorgesehen wird, wobei das Verfahren die Schritte umfaßt:
Eingreifen des verriegelnden Abschnitts (52) und des eingreifenden Abschnitts (45) des teilweisen Verriegelungsmechanismus ineinander bzw. miteinander,
wenigstens teilweises Einpassen des einen Endes (31UE) des Verbinders (30) in das einpassende bzw. Einpaßloch (17) des ersten Glieds (12),
Festlegen des zweiten Glieds (20) an dem ersten Glied (12), und
wenigstens teilweises Einsetzen des festlegenden Glieds (41) in das Festlegungsgliedloch (27A) des zweiten Glieds (20) durch das Einsetzloch (42) des festlegbaren Abschnitts (40).

6. Verbindermontageverfahren nach Anspruch 5, wobei der Schritt eines wenigstens teilweisen Einsetzens des festlegenden Glieds (41) ein Schrauben einer Schraube (41) in ein Schraubenloch (27A) des zweiten Glieds (20) durch das Einsetzloch (42) des festlegbaren Abschnitts (40) umfaßt.

7. Verbindermontageverfahren nach Anspruch 5 oder 6, wobei in dem Schritt eines wenigstens teilweisen Einsetzens des festlegenden Glieds (41) das festlegende Glied (41), vorzugsweise die Schraube (41) wenigstens teilweise in das Einsetzloch (42) des festlegbaren Abschnitts (40) eingesetzt wird, während ein Freiraum bzw. Abstand (C2) dazu definiert wird.

8. Verbindermontageverfahren nach einem oder mehreren der vorangehenden Ansprüche 5 bis 7, wobei der teilweise Verriegelungsmechanismus (45; 52) eine eingreifende bzw. Eingriffsrille (45), welche in Umfangsrichtung an der äußeren Oberfläche des anderen Endes (31BE) des Verbinders (30) ausgebildet wird, und eine verriegelnde bzw. Verriegelungsplatte (52) beinhaltet, welche von dem zweiten Glied (20) vorragt und in die eingreifende Rille (45) in einer Richtung einsetzbar ist, welche die Achsenlinie (AL) schneidet bzw. kreuzt, um damit in Eingriff gebracht zu werden.

9. Verbindermontageverfahren nach Anspruch 8, wobei die verriegelnde Platte (52) und die eingreifende Rille (45) angeordnet werden, um den Abstand (C1) dazwischen für ein Erlauben von Bewegungen des Verbinders (30) entlang von Richtungen zu definieren, welche die Achsenlinie (AL) schneiden bzw. kreuzen.

## Revendications

1. Structure de montage à raccord, dans laquelle :
une extrémité (31 UE) d'un raccord (30) doit être mise en place au moins en partie jusque dans un trou de fixation (17) ménagé dans un premier élément (12), relativement à une direction d'une ligne axiale (AL) de celui-ci ;
une partie pouvant être fixée (40) se projette depuis ou à proximité de l'autre extrémité de celui-ci dans une direction (PD) qui fait intersection avec la ligne axiale (AL) et est formée avec un trou d'insertion (42) pour un élément de fixation (41) dans une direction sensiblement parallèle à la ligne axiale (AL), et le raccord doit être assuré par la fixation de l'élément de fixation (41) inséré au moins en partie à travers le trou d'insertion (42) jusque dans un trou d'élément de fixation (27A) ménagé dans un second élément (20) devant être fixé sur le premier élément (12) ;
un mécanisme de verrouillage partiel (45 ; 52) ayant un espacement (C1) afin de permettre des mouvements du raccord (30) le long d'une ou de plusieurs directions qui fait (font) intersection avec la ligne axiale (AL) tout en évitant des mouvements du raccord (30) le long de la direction de la ligne axiale (AL) suite à l'engagement d'une partie de verrouillage (52) prévue sur chacun parmi le second élément (20) et l'autre extrémité (31 BE) du raccord (30), et une partie d'engagement (45) prévue sur l'autre est prévue entre le second élément (20) et l'autre extrémité (31 BE) du raccord (30).
**caractérisée en ce que**
le mécanisme de verrouillage partiel (45 ; 52) inclut une gorge d'engagement (45) ménagée circonférentiellement sur la surface extérieure de l'autre extrémité (31 BE) du raccord (30), et une plaque de verrouillage (52) se projetant depuis le second élément (20) et pouvant être insérée jusque dans la gorge d'engagement (45) dans une direction qui fait intersection avec la ligne axiale (AL) de manière à être engagée sur cette entrefaite.

2. Structure de montage à raccord selon la revendication 1, dans laquelle l'élément de fixation (41) comprend une vis (41) et dans laquelle le trou d'élément de fixation (27A) comprend un trou de vis (27A) jusque dans lequel la vis (41) peut être vissée.

3. Structure de montage à raccord selon l'une ou plus des revendications précédentes, dans laquelle l'élément de fixation (41), de préférence la vis (41), peut être inséré au moins en partie jusque dans le trou d'insertion (42) de la partie pouvant être fixée (40) tout en y définissant un espacement (C2).

4. Structure de montage à raccord selon l'une ou plus des revendications précédentes, dans laquelle la plaque de verrouillage (52) et la gorge d'engagement (45) doivent être agencées de manière à définir l'espacement (C1) entre elles afin de permettre des mouvements du raccord (30) le long des directions qui font intersection avec la ligne axiale (AL).

5. Procédé de montage par raccord pour une structure de montage à raccord selon l'une des revendications précédentes, dans lequel des mouvements du raccord (30) le long d'une ou de plusieurs directions qui fait (font) intersection avec la ligne axiale (AL) sont permis au moyen d'un mécanisme de verrouillage partiel (45 ; 52) qui a un espacement (C1) tout en évitant des mouvements du raccord (30) le long de la direction de la ligne axiale (AL) suite à l'engagement d'une partie de verrouillage (52) prévue sur chacun parmi le second élément (20) et l'autre extrémité (31 BE) du raccord (30), et une partie d'engagement (45) prévue sur l'autre est prévue entre le second élément (20) et l'autre extrémité (31 BE) du raccord (30), le procédé comprenant les étapes suivantes :
l'engagement de la partie de verrouillage (52) et de la partie d'engagement (45) du mécanisme de verrouillage partiel l'une avec l'autre ;
la mise en place au moins en partie de la une extrémité (31 UE) du raccord (30) jusque dans le trou de fixation (17) du premier élément (12) ;
la fixation du second élément (20) sur le premier élément (12) ; et
l'insertion au moins en partie de l'élément de fixation (41) jusque dans le trou d'élément de fixation (27A) du second élément (20) à travers le trou d'insertion (42) de la partie pouvant être fixée (40).

6. Procédé de montage par raccord selon la revendication 5, dans lequel l'étape d'insérer au moins en partie l'élément de fixation (41) comprend le vissage d'une vis (41) jusque dans un trou de vis (27A) du second élément (20) à travers le trou d'insertion (42) de la partie pouvant être fixée (40).

7. Procédé de montage par raccord selon l'une ou l'autre des revendications 5 et 6, dans lequel, dans l'étape d'insérer au moins en partie l'élément de fixation (41), l'élément de fixation (41), de préférence la vis (41), est inséré au moins en partie jusque dans le trou d'insertion (42) de la partie pouvant être fixée (40) tout en y définissant un espacement (C2).

8. Procédé de montage par raccord selon l'une ou plus des revendications précédentes 5 à 7, dans lequel le mécanisme de verrouillage partiel (45 ; 52) inclut une gorge d'engagement (45) ménagée circonférentiellement sur la surface extérieure de l'autre extrémité (31 BE) du raccord (30), et une plaque de verrouillage (52) se projetant depuis le second élément (20) et pouvant être insérée jusque dans la gorge d'engagement (45) dans une direction qui fait intersection avec la ligne axiale (AL) de manière à être engagée sur cette entrefaite.

9. Procédé de montage par raccord selon la revendication 8, dans lequel la plaque de verrouillage (52) et la gorge d'engagement (45) sont agencées de manière à définir l'espacement (C1) entre elles afin de permettre des mouvements du raccord (30) le long des directions qui font intersection avec la ligne axiale (AL).
